# EUROPÄISCHE PATENTSCHRIFT

(11) **EP 3 183 212 B1**
(45) Veröffentlichungstag und Bekanntmachung des Hinweises auf die Patenterteilung: **06.06.2018**
(21) Anmeldenummer: 15756370.1
(22) Anmeldetag: 10.08.2015
(51) Int. Cl.: C01B 33/035, C23C 16/01, C23C 16/02, C23C 16/24

(54) **VERFAHREN ZUR REINIGUNG EINES REAKTORS ZUR HERSTELLUNG VON POLYKRISTALLINEM SILICIUM**
METHOD FOR CLEANING A REACTOR FOR PRODUCING POLYCRYSTALLINE SILICON
PROCÉDÉ DE NETTOYAGE D'UN RÉACTEUR POUR LA PRODUCTION DE SILICIUM POLYCRISTALLIN

(30) Priorität: 18.08.2014 DE 102014216325
(43) Veröffentlichungstag der Anmeldung: 28.06.2017
(73) Patentinhaber: Wacker Chemie AG, 81737 München (DE)
(72) Erfinder: POPP, Friedrich, Ooltewah, Tennessee 37363 (US); HERTLEIN, Harald, 84489 Burghausen (DE)
(74) Vertreter: Potten, Holger
(86) Internationale Anmeldenummer: PCT/EP2015/068362
(87) Internationale Veröffentlichungsnummer: WO 2016/026728

(56) Entgegenhaltungen:
- EP-A1- 1 886 971
- EP-A1- 2 583 943
- US-B1- 6 296 716
- DATABASE WPI Week 201311 Thomson Scientific, London, GB; AN 2013-B51149 XP002747721, -& JP 2013 018675 A (SHINETSU CHEM IND CO LTD) 31. Januar 2013 (2013-01-31)

## Beschreibung

Gegenstand der Erfindung ist ein Verfahren zur Herstellung von polykristallinem Silicium.

Die Herstellung von polykristallinem Silicium erfolgt üblicherweise mittels des Siemens-Verfahrens. Dabei wird ein Reaktionsgas umfassend eine oder mehrere Silicium enthaltende Komponenten und gegebenenfalls Wasserstoff mittels Düsen in einen Reaktor umfassend durch direkten Stromdurchgang erhitzte Trägerkörper eingeleitet, wobei sich an den Trägerkörpern Silicium in fester Form abscheidet. Als Silicium enthaltende Komponenten werden bevorzugt Silan (SiH₄), Monochlorsilan (SiH₃Cl), Dichlorsilan (SiH₂Cl₂), Trichlorsilan (SiHCl₃), Tetrachlorsilan (SiCl₄) oder Mischungen der genannten Stoffe eingesetzt.

Das Siemens-Verfahren wird üblicherweise in einem Abscheidereaktor (auch "Siemens-Reaktor" genannt) durchgeführt. In der gebräuchlichsten Ausführungsform umfasst der Reaktor eine metallische Bodenplatte und eine kühlbare Glocke, die auf die Bodenplatte gesetzt ist, so dass ein Reaktionsraum im Inneren der Glocke entsteht. In EP 2 077 252 A2 wird der typische Aufbau eines in der Herstellung von Polysilicium zum Einsatz kommenden Reaktortyps beschrieben.

Die Bodenplatte ist mit einer oder mehreren Gaseinlassöffnungen und einer oder mehreren Abgasöffnungen für Reaktionsgase sowie mit Halterungen versehen, mit deren Hilfe die Trägerkörper im Reaktionsraum gehalten und durch Elektroden mit elektrischem Strom versorgt werden.

Die Trägerkörper werden üblicherweise von je zwei sog. Dünnstäben und einer waagrechten Brücke gebildet. Durch die Brückenkopplung wird die typische U-Form der Trägerkörper erzeugt. Die Trägerkörper bestehen üblicherweise aus polykristallinem Silicium. Die Länge der Dünnstäbe, auf denen polykristallines Silicium abgeschieden wird, kann mehrere Meter betragen (üblich sind etwa 2 bis 3 m).

In EP 2 077 252 A2 wird es prozesstechnisch als vorteilhaft angesehen, Düsen für die Reaktionsgasversorgung während des Abscheideprozesses zu- bzw. abzuschalten. Dazu wird der Anteil geschlossener Düsen in Abhängigkeit von Prozesszeit oder Stabdurchmesser geregelt. Ziel dieser Maßnahme ist es, bei wachsendem Stabdurchmesser eine optimale Gasversorgung aller Stäbe - insbesondere im oberen Bereich - sicherzustellen.

In EP 2 067 744 A2 wird ein Herstellungsverfahren für polykristallines Silicium offenbart, bei dem die Einströmgeschwindigkeit des Reaktionsgases, durch das Silicium abgeschieden wird, nach einem ersten Stabilisierungsschritt zunächst stark und dann langsamer gesteigert wird, um die Versorgung der Trägerkörper mit Reaktionsgas zu verbessern, und anschließend im Wachstumsschritt reduziert wird, um eine effiziente Abscheidung sicherzustellen. Es wird betont, dass nur die Versorgung mit Reaktionsgas geregelt wird und somit keinerlei Modifikationen an den Reaktoren erforderlich sind.

Allerdings zeigen die in EP 2 077 252 A2 und in EP 2 067 744 A2 beschriebenen Verfahren ein verstärktes Umfallen von Stäben im Reaktor. Dies hängt vermutlich mit den abrupten Änderungen der Einströmgeschwindigkeiten des Reaktionsgases zusammen.

Stäbe können beim Umfallen auch andere benachbarte Stäbe umwerfen. Dies verursacht einen beträchtlichen wirtschaftlichen Schaden, insbesondere wenn es beim Umfallen der Siliciumstäbe zu Beschädigungen der Reaktorwandung kommt. Die umgefallenen Siliciumstäbe werden dabei durch den Kontakt mit der Reaktorwandung verunreinigt und müssen an der Oberfläche gereinigt werden. Zusätzlich können umgefallene Chargen nur mit erhöhtem Aufwand aus dem Reaktor ausgebaut werden. Dabei wird die Oberfläche des Siliciums weiter kontaminiert.

US 20120048178 A1 offenbart ein Verfahren zur Herstellung von polykristallinem Silicium, bei dem eine Archimedes-Zahl, die Strömungsverhältnisse im Reaktor beschreibt, in Abhängigkeit vom Füllgrad FG innerhalb bestimmter Bereiche liegt. Gegenüber dem Verfahren nach EP 2 067 744 A2 führt dies zu einer niedrigeren Umfallquote.

Von niedrigeren Umfallquoten wird im Stand der Technik auch berichtet, wenn spezielle Elektroden zum Einsatz kommen.

Elektroden bestehen üblicherweise im unteren Teil aus einem zylindrischen Grundkörper und im oberen Teil aus einer Kegelspitze. An der Kegelspitze ist eine Bohrung zur Aufnahme des Dünnstabs angebracht. Das untere Ende der Elektrode wird dabei in eine metallische Elektrodenhalterung gesetzt, über die der Strom zugeführt wird.

Gemäß US 2011226628 A1 wurde überraschenderweise gefunden, dass eine Elektrode aus Kohlenstoff mit einer kegel- oder pyramidenförmigen Spitze, die von einem hochgezogenen Rand umgeben ist, beim Wachstum des darin befestigten Dünnstabes eine verbesserte Wärmeableitung und eine verbesserte Verteilung der Stromdichte in Relation zur Stabdicke aufweist.
Beim Beginn einer Abscheidung von Polysilicium auf einem Dünnstab, d.h. bei noch dünnem Stabdurchmesser, wächst bei einer solchen Elektrode der Stabfuss zuerst, wie bei einer Standardelektrode, nur auf die Spitze auf. Bei Verwendung eines Werkstoffs für die Elektrode mit geringer spezifischer Wärmeleitung ist die Wärmeableitung bei dünnem Stabdurchmesser über die Elektrode gering. Die Elektrodenspitze verwächst damit gut mit der Elektrode und wächst schnell in den Stabfuss ein. Damit wird bereits zu Beginn der Abscheidung für eine hohe Standfestigkeit gesorgt und das Risiko von umfallenden Stäben vor Erreichen des Enddurchmessers minimiert.

US 2013011581 A2 offenbart eine Vorrichtung zum Schutz von Elektrodenhalterungen in CVD Reaktoren, umfassend eine zur Aufnahme eines Dünnstabs geeigneten Elektrode auf einer Elektrodenhalterung aus einem elektrisch leitfähigen Material, die in einer Aussparung einer Bodenplatte angebracht ist, wobei ein Zwischenraum zwischen Elektrodenhalterung und Bodenplatte mit einem Dichtungsmaterial abgedichtet ist und das Dichtungsmaterial durch einen ein- oder mehrteilig aufgebauten, ringförmig um die Elektroden angeordneten Schutzkörper geschützt wird, wobei der Schutzkörper in Richtung der Elektrodenhalterung zumindest abschnittsweise in seiner Höhe zunimmt.
Diese Anordnung des Schutzkörpers ermöglicht ein schnelles und gleichmäßiges Aufwachsen von Silicium am Stabfuss. Es hat sich gezeigt, dass das im Stand der Technik oftmals beobachtete ungleichmäßige Aufwachsen des Siliciums, was zu einem Umfallen des Stabs führen kann, dadurch weitgehend verhindert werden kann, also eine Reduktion der Umfallquote erreicht wird.
Im Stand der Technik ist also bekannt, Umfallquoten dadurch zu reduzieren, dass die Strömungsverhältnisse im Reaktor geeignet gewählt werden oder dass spezielle Elektroden zum Einsatz kommen.
Aus US 7927571 B2 ist es bekannt, nach dem Erreichen eines gewünschten Durchmessers die Abscheidung zu beenden, die entstandenen polykristallinen Siliciumstäbe auf Raumtemperatur abzukühlen, dann die Glocke zu öffnen und die polykristallinen Siliciumstäbe mit Ausbauhilfen zur Weiterverarbeitung zu entnehmen, und anschließend Glocke und Bodenplatte des Reaktors zu reinigen und mit neuen Elektroden und Dünnstäben für die nächste Abscheidungscharge zu versehen. JP 2013 018675 A beschreibt ein Verfahren zur Herstellung von polykristallinem Silicium, bei dem polykristallines Silicium auf durch direkten Stromdurchgang erhitzten Trägerkörpern abgeschieden wird, wodurch polykristalline Siliciumstäbe erzeugt werden, wobei nach einem Ausbau der polykristallinen Siliciumstäbe aus dem Reaktor und vor einer Bestückung des Reaktors mit neuen Trägerkörpern die Bodenplatte des Reaktors gereinigt wird, dadurch gekennzeichnet, dass eine Reinigung der Bodenplatte erfolgt, die wenigstens zwei Reinigungschritte umfasst, wobei bei den wenigstens zwei Reinigungsschritten wenigstens zwei Reinigungsmedien mit unterschiedlichem Aggregatzustand zum Einsatz kommen (Wasser, Bürste, Tuch, Beispiel 1, als Alternativen werden genannt: Wasser (pressure jet), Trockeneis Pellets, Sauger.

EP 2 583 943 A1 beschreibt die Reinigung des Gesamtreaktors, d.h. auch der Bodenplatte, mittels Kontakt mit Wasser, Vakuum, Inertgas.

US 6 296 716 B1 beschreibt dass bei einem Verfahren gemäss der vorliegenden Anmeldung die Bodenplatte des Reaktors periodisch gereinigt wird. Das Reinigungsverfahren wird nicht spezifiziert.

Die Aufgabe der Erfindung bestand darin, die Umfallquoten von polykristallinen Siliciumstäben bei der Abscheidung von polykristallinem Silicium weiter zu reduzieren.

Die Aufgabe der Erfindung wird gelöst durch ein Verfahren zur Herstellung von polykristallinem Silicium, bei dem polykristallines Silicium auf durch direkten Stromdurchgang erhitzten Trägerkörpern abgeschieden wird, wodurch polykristalline Siliciumstäbe erzeugt werden, wobei die Trägerkörper auf einer Bodenplatte eines Reaktors gehalten und über Elektroden mit Strom versorgt werden, wobei die Abscheidung von polykristallinem Silicium beendet wird, wenn die polykristallinen Siliciumstäbe eine gewünschten Enddurchmesser erreicht haben, wobei die polykristallinen Siliciumstäbe nachfolgend aus dem Reaktor entfernt werden und der Reaktor mit neuen Trägerkörpern bestückt wird, um weitere polykristalline Silciumstäbe zu erzeugen, wobei nach einem Ausbau der polykristallinen Siliciumstäbe aus dem Reaktor und vor einer Bestückung des Reaktors mit neuen Trägerkörpern die Bodenplatte des Reaktors gereinigt wird, dadurch gekennzeichnet, dass die Bodenplatte nach jedem Stabausbauvorgang abgesaugt und anschließend mit einem flüssigen oder einem feststoffhaltigen Reinigungsmedium gereinigt wird.

Überraschenderweise wird durch eine solche spezielle Reinigung der Bodenplatte des Reaktors die Umfallquote deutlich reduziert.

Vorzugweise umfasst ein im Rahmen des Verfahrens verwendetes flüssiges Reinigungsmedium Wasser. Vorzugsweise enthält es vollentsalztes Wasser (VE-Wasser).

Ebenso ist es bevorzugt, ein flüssiges Reinigungsmedium einzusetzen, dass einen Alkohol enthält.

Falls ein feststoffhaltiges Reinigungsmedium zum Einsatz kommt, ist es bevorzugt, wenn das Reinigungsmedium ein Oxid enthält. Dabei handlet es sich vorzugweise um Siliciumdioxid, Aluminiumoxid, Carbonate, Silikate, Talk oder Bims.

Vorzugweise erfolgt eine Reinigung der Bodenplatte, zumindest nach jeweils sechs Stabausbauvorgängen und vor dem sechsten Rüstvorgang. Nach jedem Abscheidevorgang werden die erzeugten polykristallinen Siliciumstäbe aus dem Reaktor entnommen (Stabausbau). Unter einem Rüstvorgang ist zu verstehen, dass der Reaktor mit neuen Trägerkörpern bestückt wird, indem neue Trägerkörper in den Reaktor eingebracht, an die Elektroden angeschlossen und auf der Bodenplatte fixiert werden.
Besonders bevorzugt erfolgt eine Reinigung der Bodenplatte nach drei oder nach zwei Stabausbauvorgängen.
Ganz besonders bevorzugt ist es, wenn die Reinigung der Bodenplatte nach jedem Abscheidevorgang und dem anschließendem Stabausbau erfolgt.
In einer Ausführungsform erfolgt nach jedem Stabausbauvorgang eine Reinigung der Bodenplatte mit einem gasförmigen Reinigungsmedium. Die Bodenplatte wird dabei abgesaugt (Luft als Reinigungsmedium, die abgesaugt wird). Nach jedem sechsten Stabausbauvorgang erfolgt eine Reinigung der Bodenplatte, die zwei Schritte umfasst. Im ersten Schritt wird abgesaugt. Im zweiten Schritt erfolgt eine Reinigung der Bodenplatte mit einem flüssigen oder mit einem festen oder feststoffhaltigen Reinigungsmedium.
In einer weiteren bevorzugten Ausführungsform erfolgt nach jedem Stabausbauvorgang eine Reinigung der Bodenplatte mit einem gasförmigen Reinigungsmedium. Die Bodenplatte wird dabei abgesaugt. Zusätzlich erfolgt nach der Reinigung mit dem gasförmigen Reinigungsmedium stets eine Reinigung der Bodenplatte mit einem flüssigen oder mit einem festen oder feststoffhaltigen Reinigungsmedium. Besonders bevorzugt erfolgt ein Absaugen der Bodenplatte mit einer anschließenden Nassreinigung.

Vorzugweise wird die Bodenplatte nach einer etwaigen Reinigung mit einem flüssigen Reinigungsmedium getrocknet.

Dies kann dadurch erfolgen, dass ein Gas enthaltend Stickstoff, im einfachsten Fall Luft, vorzugweise Reinraumluft, zur Bodenplatte geströmt wird.

Ebenso ist es möglich, eine Flüssigkeit, die die Verdunstung von Wasser fördert, zum Trocknen der Bodenplatte zu verwenden.Vorzugweise wird die Bodenplatte durch Zuführung eine Alkohols getrocknet.

Durch das Trocknen der Bodenplatte lassen sich Verfärbungen auf den polykristallinen Siliciumstäben vermeiden, die zu beobachten sind, wenn nach einer Nassreinigung der Bodenplatte Rückstände von Feuchtigkeit auf der Bodenplatte verbleiben.

Die Reinigung kann manuell erfolgen. Ebenso können für die Bodenreinigung Reinigungsautomaten zum Einsatz kommen wie Bürst-, Wasser- und Staubsauger, Kehrmaschinen, Scheuersaugmaschinen, Einscheibenmaschinen.

Vorzugweise erfolgt die Reinigung der Bodenplatte unter Verwendung eines Reinigungshilfsmittels, ausgewählt aus der Gruppe bestehend aus Poliermaschine, Schwamm, Poliertuch, Reinigungstuch, Bürste, Staubsauger, Kehrblech und Besen.

Besonders bevorzugt ist die Verwendung eines Poliertuchs oder einer Poliermaschine.

Vorzugweise werden vor der Reinigung Öffnungen der Bodenplatte verschlossen. Besonders bevorzugt ist es, wenn die Öffnungen gas- und wasserdicht verschlossen sind. Dazu eignen sich beispielsweise Stopfen oder Kappen.

Unter Anwendung der Erfindung steigen gewisse Störungsquoten, insbesondere die Umfallquote, bei gleichem Abscheiderezept nicht an. Weiterhin wird das Material nicht durch Anlauffarben bei der erfindungsgemäßen Handhabung der Bodenplatten verunreinigt.

Bezüglich der Abscheidung von polykristallinem Silicium kommt vorzugweise das in US 20120048178 A1 beschriebene Verfahren zur Anwendung.

### Beispiele

### Beispiel 1

In einer Stichprobe 1 erfolgte nach jedem Stabausbau ein Absaugen der Bodenplatte (gasförmiges Reinigungsmedium / Luft) sowie anschließend eine Nassreinigung der Bodenplatte.

In einer Stichprobe 2 erfolgte nach jedem Stabausbau ein Absaugen der Bodenplatte, eine zusätzliche Nassreinigung jedoch nur nach jedem sechsten Stabausbau.

Für beide Stichproben wurden die Umfallquoten U1 für dünne Stäbe (Durchmesser kleiner als 100 mm) und die Umfallquoten U2 für dicke Stäbe (Durchmesser größer als 100 mm) ermittelt.

Die Ergebnisse sind in **Tabelle 1** dargestellt.

Stichprobe 2 zeigt für dünne Stäbe eine um 100% erhöhte Umfallquote gegenüber Stichprobe 1. Für dicke Stäbe liegt die Umfallquote bei Stichprobe 2 um 70% über dem Referenzwert von Stichprobe 1.

Der Abscheidevorgang und die eingesetzten Grafitelektroden (Abscheiderezept A) waren bei beiden Stichproben identisch.

**Tabelle 1**

| Stichprobe | Abscheiderezept | Reinigungszyklus (Nassreinigungen/Betriebsfahrten) | U1 | U2 |
|---|---|---|---|---|
| 1 | A | 1/1 | x | y |
| 2 | A | 1/6 | 2x | 1.7y |

Dieses Beispiel soll veranschaulichen, dass die Art der Reinigung einen erheblichen Einfluss auf die Umfallquote hat. Ohne eine erfindungsgemäße Reinigung der Bodenplatte, wären die Umfallquoten gegenüber Stichprobe 2 um ein Vielfaches höher.

Wie die Ergebnisse von Stichprobe 1 zeigen, sollte idealerweise nach jedem Stabausbau sowohl ein Absaugen der Bodenplatte und eine anschließende Nassreinigung der Bodenplatte erfolgen. Dies führt zu minimalen Umfallquoten.

Bei einer nicht nass gereinigten Bodenplatte ist der Reflexionsgrad der Bodenplatte geringer als bei einer nass gereinigten Bodenplatte. Da durch die nicht nass gereinigte Bodenplatte weniger Wärme zu den Stabfüßen hin zurück reflektiert wird, sind die Stabfüße an der Oberfläche kälter als bei einer nass gereinigten Bodenplatte. Eine nass gereinigte Bodenplatte kann mehr Wärme zurück reflektieren. Da die Temperaturen im Inneren der Stabfüße bei gleichem Abscheiderezept identisch sind, entstehen unterschiedliche Temperaturgradienten. Der höhere Temperaturgradient bei nicht nass gereinigter Bodenplatte dürfte für eine höhere Umfallquote verantwortlich sein.

### Beispiel 2

Weiterhin wurden Stichproben 3 und 4 untersucht. Bei beiden Stichproben erfolgten ein Absaugen der Bodenplatte sowie eine Nassreinigung der Bodenplatte mit Wasser und anschließender Trocknung der Bodenplatte.

Bei Stichprobe 3 wurden die Abgas- und Zugasöffnungen der Bodenplatte vor der Nassreinigung gas- und wasserdicht verschlossen. Bei Stichprobe 4 wurde darauf verzichtet.

Der Abscheidevorgang und die eingesetzten Grafitelektroden (Abscheiderezept A) waren wie bei **Beispiel 1** bei beiden Stichproben identisch.

Es zeigte sich, dass die Quote der Chargen mit durch Wasser verursachten Verfärbungen bei der Stichprobe 4 etwa 10 mal höher war als bei der Stichprobe 3. Dies ist auch in **Tabelle 2** dargestellt.

**Tabelle 2**

| Stichprobe | Abscheiderezept | Verfärbungsquote |
|---|---|---|
| 3 | A | x |
| 4 | A | 10x |

Es wird davon ausgegangen, dass selbst kleine Mengen von Feuchtigkeit, die während der Reinigung in die Öffnungen der Bodenplatte eindringen und im Trocknungsschritt nicht vollständig entfernt werden, solche Verfärbungen an den polykristallinen Siliciumstäben verursachen können.

## Patentansprüche

1. Verfahren zur Herstellung von polykristallinem Silicium, bei dem polykristallines Silicium auf durch direkten Stromdurchgang erhitzten Trägerkörpern abgeschieden wird, wodurch polykristalline Siliciumstäbe erzeugt werden, wobei die Trägerkörper auf einer Bodenplatte eines Reaktors gehalten und über Elektroden mit Strom versorgt werden, wobei die Abscheidung von polykristallinem Silicium beendet wird, wenn die polykristallinen Siliciumstäbe einen gewünschten Enddurchmesser erreicht haben, wobei die polykristallinen Siliciumstäbe nachfolgend aus dem Reaktor entfernt werden und der Reaktor mit neuen Trägerkörpern bestückt wird, um weitere polykristalline Silciumstäbe zu erzeugen, wobei nach einem Ausbau der polykristallinen Siliciumstäbe aus dem Reaktor und vor einer Bestückung des Reaktors mit neuen Trägerkörpern die Bodenplatte des Reaktors gereinigt wird, **dadurch gekennzeichnet, dass** die Bodenplatte nach jedem Stabausbauvorgang abgesaugt und anschließend mit einem flüssigen oder einem feststoffhaltigen Reinigungsmedium gereinigt wird.

2. Verfahren nach Anspruch 1, wobei die Reinigung der Bodenplatte einen Reinigungsschritt mit einem flüssigen Reinigungsmedium umfasst und die Bodenplatte nach diesem Reinigungsschritt getrocknet wird.

3. Verfahren nach einem der Ansprüche 1 oder 2, wobei vor der Reinigung der Bodenplatte Öffnungen der Bodenplatte gas- und wasserdicht verschlossen werden.

## Claims

1. Process for producing polycrystalline silicon where polycrystalline silicon is deposited on support bodies heated by direct passage of current to afford polycrystalline silicon rods, wherein the support bodies are held on a bottom plate of a reactor and supplied with current via electrodes, wherein the deposition of polycrystalline silicon is terminated when the polycrystalline silicon rods have achieved a desired final diameter, wherein the polycrystalline silicon rods are subsequently removed from the reactor and the reactor is fitted with new support bodies to afford further polycrystalline silicon rods, wherein after removal of the polycrystalline silicon rods from the reactor and before fitting of the reactor with new support bodies the bottom plate of the reactor is cleaned, **characterized in that** the bottom plate is suctioned-off and subsequently cleaned with a liquid or solid-containing cleaning medium after every rod removal procedure.

2. Process according to Claim 1, wherein the cleaning of the bottom plate comprises a cleaning step with a liquid cleaning medium and the bottom plate is dried after this cleaning step.

3. Process according to either of Claims 1 and 2, wherein before the cleaning of the bottom plate, openings in the bottom plate are sealed so as to be impervious to gas and water.

## Revendications

1. Procédé pour la production de silicium polycristallin, dans lequel on dépose du silicium polycristallin sur des corps porteurs chauffés par passage direct de courant, de manière à produire des barres de silicium polycristallin, les corps porteurs étant maintenus sur un plateau de fond d'un réacteur et alimentés en courant par des électrodes, le dépôt de silicium polycristallin étant terminé lorsque les barres de silicium polycristallin ont atteint un diamètre final souhaité, les barres de silicium polycristallin étant ensuite retirées du réacteur et le réacteur étant chargé avec de nouveaux corps porteurs afin de produire de nouvelles barres de silicium polycristallin, le plateau de fond du réacteur étant nettoyé après un retrait des barres de silicium polycristallin hors du réacteur et avant une charge du réacteur avec de nouveaux corps porteurs, **caractérisé en ce qu'**on aspire le plateau de fond après chaque opération de retrait des barres et ensuite on le nettoie avec un produit de nettoyage liquide ou un produit de nettoyage contenant des matières solides.

2. Procédé selon la revendication 1, dans lequel le nettoyage du plateau de fond comprend une étape de nettoyage avec un produit de nettoyage liquide et après cette étape de nettoyage on sèche le plateau de fond.

3. Procédé selon l'une quelconque des revendications 1 et 2, dans lequel avant le nettoyage du plateau de fond on obture de façon étanche à l'eau et aux gaz les orifices du plateau de fond.
